# EUROPÄISCHE PATENTSCHRIFT

(11) **EP 3 787 047 B1**
(45) Veröffentlichungstag und Bekanntmachung des Hinweises auf die Patenterteilung: **02.03.2022**
(21) Anmeldenummer: 20193147.4
(22) Anmeldetag: 27.08.2020
(51) Int. Cl.: H01L 31/101, H01L 31/18, H01L 31/02, H01L 31/09, H03K 17/78, H01L 31/16

(54) **PHOTOSCHALTERSTRUKTUR, ZUGEHÖRIGES HERSTELLUNGSVERFAHREN SOWIE ANORDNUNG MIT EINER PHOTOSCHALTERSTRUKTUR UND EINER SPANNUNGSQUELLE**
PHOTOSWITCH STRUCTURE, ASSOCIATED PRODUCTION METHOD AND ASSEMBLY WITH A PHOTOSWITCH STRUCTURE AND VOLTAGE SOURCE
STRUCTURE DE COMMUTATEUR PHOTOÉLECTRIQUE, PROCÉDÉ DE FABRICATION ASSOCIÉ AINSI QU'AGENCEMENT DOTÉ D'UNE STRUCTURE DE COMMUTATEUR PHOTOÉLECTRIQUE ET D'UNE SOURCE DE TENSION

(30) Priorität: 28.08.2019 DE 102019123088
(43) Veröffentlichungstag der Anmeldung: 03.03.2021
(73) Patentinhaber: TPMT-TEPIN MICROELECTRONIC TECHNOLOGY LTD. CO., Chengdu, Sichuan 610054 (CN)
(72) Erfinder: HU, Sifu, Chengdu, Sichuan 610054 (CN); HU, Jiajie, Chengdu, Sichuan 610054 (CN); HU, Felix, Chengdu, Sichuan 610054 (CN)
(74) Vertreter: Dr. Gassner & Partner mbB

(56) Entgegenhaltungen:
- CN-A- 104 505 426
- DE-A1- 1 464 946
- JP-A- H0 325 984
- US-A1- 2007 092 812
- US-A1- 2019 131 482

## Beschreibung

Die vorliegende Erfindung betrifft eine Photoschalterstruktur, ein Verfahren zur Herstellung einer Photoschalterstruktur sowie eine Anordnung mit einer Solarzelle und einer Spannungsquelle.

Die US 2019/131482 A1 offenbart einen dreidimensionalen linearen photonischen Schalter mit zwei Leitern und einem photoleitenden Material, das zwischen den Leitern positioniert ist. Die Leiter sind zum Erzeugen eines elektrischen Felds durch das photoleitende Material bei Anlegen eines Spannungswerts zwischen den Leitern eingerichtet. Licht kann durch das photoleitende Material absorbiert werden, wodurch ein Durchbruch des photoleitenden Materials erfolgt, dieses leitend wird und ein Strom durch das photoleitende Material zwischen den Leitern fließt. Das photoleitende Material kann Silizium enthalten.

Die US 2007/0092812 A1 offenbart einen photoleitenden Schalter mit einem photoleitenden Substrat und zwei elektrisch mit dem Substrat verbundenen Elektroden. Das Substrat weist wenigstens zwei photoleitende Schichten auf. Eine Seite des Substrats ist mit einem Dielektrikum beschichtet.

Photoschalterstrukturen auf Grundlage eines Halbleitersubstrats können insbesondere für photoleitfähige Halbleiterschalter (Semiconductor Photoconductive Switch - PCCS) verwendet werden und kommen beispielsweise als Mikrowellenpulsquelle, für die Ultrabreitbandkommunikation und bei Hochleistungs-Ultrabreitband-Radargeräten zum Einsatz. Nach dem Stand der Technik sind Photoschalterstrukturen auf Basis von halbisolierenden Halbleiterblockmaterialien, wie Galliumarsenid, Siliziumkarbid oder Galliumnitrid, mit einer Vorspannung zwischen 2 kV und 300 kV bekannt, die von einem Hochenergielaser getriggert werden.

Obwohl solche Photoschalterstrukturen ausgezeichnete elektrische Charakteristika aufweisen, sind sich technisch hoch kompliziert, sehr teuer und weisen nur eine geringe Zuverlässigkeit und Lebensdauer auf.

Der Erfindung liegt die Aufgabe zugrunde, eine demgegenüber verbesserte Photoschalterstruktur auf Halbleiterbasis anzugeben.

Zur Lösung dieser Aufgabe wird erfindungsgemäß eine Photoschalterstruktur gemäß Anspruch 1 vorgeschlagen. Vorteilhafte Ausgestaltungen sind Gegenstand der abhängigen Ansprüche.

Die Erfindung beruht auf der Überlegung, heiße Ladungsträger zu extrahieren, bevor diese auf eine Umgebungstemperatur abgekühlt sind, um die heißen Ladungsträger mit überschüssiger kinetischer Energie in elektrische Energie umzuwandeln. Die Photoschalterstruktur beschleunigt die Extraktion heißer Ladungsträger und reduziert den Verlust von überschüssiger Wärmeenergie, die durch Kollisionen der heißen Ladungsträger verursacht wird, weil diese durch das von der externen Spannung erzeugte elektrische Feld von einer ungeordneten thermischen Diffusionsbewegung in eine Driftbewegung übergehen. Im nichtlinear leitenden Zustand führt die Kollision heißer Ladungsträger und einem Gitter des Halbleitersubstrats zu einem neuen Elektronen-Loch-Paar. Durch die Verwendung der SiNx-Schicht wird eine Si-SiNx-Dünnfilmquantenverbindung realisiert, wobei eine Energiebrandbreite von weniger als 10 meV realisiert werden kann. Durch eine Injektion heißer Ladungsträger in die n-Zone kann der nichtlinear leitende Zustand bereits bei einer externen Spannung zwischen 2 und 3 Volt bei einer Bestrahlung mit Sonnenlicht eingenommen werden. Dadurch ist die erfindungsgemäße Photoschalterstruktur auch zur Verwendung bei einer Solarzelle geeignet.

Vorteilhafterweise ist die erfindungsgemäße Photoschalterstruktur einfach und aufwandsarm herstellbar.

Die Photoschalterstruktur wird typischerweise durch eine vertikale Struktur ausgebildet. Typischerweise ist die Anode aus Silber gebildet. Das Halbleitersubstrat ist typischerweise auf Basis von kristallinem Silizium gebildet. Das Halbleitersubstrat hat typischerweise eine rechteckige Grundfläche mit Seitenlängen zwischen 1 cm und 16 cm. Dadurch werden auch eine hohe Zuverlässigkeit und lange Lebensdauer erzielt. Bevorzugt ist die Grundfläche quadratisch. Die externe Spannung beträgt bevorzugt wenigstens 2 Volt, besonders bevorzugt wenigstens 3 Volt, und/oder bevorzugt höchstens 7 Volt, besonders bevorzugt höchstens 6 Volt. Vorteilhafterweise ist die n-Zone hoch dotiert.

Es wird bevorzugt, wenn die erfindungsgemäße Photoschalterstruktur dazu eingerichtet ist, ihren flächenbezogenen Widerstand beim Übergang von einem nicht mit Licht bestrahlten Zustand in den nichtlinear leitenden Zustand um einen Faktor zwischen 300 und 4000 zu verringern. Typischerweise liegt der flächenbezogene Widerstand des Fotoschalters im nichtleitenden Zustand bei über 2000 Ω·cm⁻² und im nichtlinearen leitenden Zustand zwischen 0,5 und 3 Ω·cm⁻².

In vorteilhafter Ausgestaltung der erfindungsgemäßen Photoschalterstruktur durchdringt die Kathode die SiNx-Schicht.

Besonders bevorzugt ist bei der erfindungsgemäßen Photoschalterstruktur vorgesehen, dass die Anode einen die SiNx-Schicht kontaktierenden Hauptabschnitt und ein oder mehrere vom Hauptabschnitt abstehende, die SiNx-Schicht nicht kontaktierende Verbindungsabschnitte aufweist, wobei von dem oder einem jeweiligen Verbindungsabschnitt ein oder mehrere die SiNx-Schicht kontaktierende Nebenabschnitte abstehen. So wird die vertikale Photoschalterstruktur an einer Vielzahl von Stellen über die Solarzelle verteilt ausgebildet.

Dabei wird es bevorzugt, wenn die Verbindungabschnitte an zwei gegenüberliegenden Seiten des Hauptabschnitts ausgebildet sind.

Erfindungsgemäß weist das Halbleitersubstrat eine auf der n-Zone ausgebildete Isolierschicht, insbesondere aus Siliziumdioxid, auf. Die Isolierschicht weist bevorzugt eine Dicke zwischen 5 und 10 nm auf. So wird ein ultradünner Isolierfilm realisiert.

Erfindungsgemäß ist ein flächenbezogener Wasserstoffgehalt in Bereichen der SiNx-Schicht, die zwischen einem von der Anode kontaktierten Bereich und dem Halbleitersubstrat liegen, wenigstens um den Faktor 10, bevorzugt um den Faktor 100, höher, als in übrigen Bereichen der SiNx-Schicht. So wird um die Anode herum ein hoher Transmissionsgrad und eine geringe Wärmeleitfähigkeit mit einem graduell vergrößerten Brechungsindex realisiert.

Es ist bei der erfindungsgemäßen Solarzelle bevorzugt ferner vorgesehen, dass die SiNx-Schicht auf einer vom Halbleitersubstrat abgewandten Seite konkav ausgebildet ist. Typischerweise beträgt die Dicke der SiNx-Schicht an ihrer dünnsten Stelle wenigstens 800 Å, insbesondere wenigstens 1500 Å, und/oder und an ihrer dicksten Stelle, insbesondere an ihrem äußersten Rand, höchstens 3000 Å, insbesondere höchstens 1 µm. Die konkave Ausbildung lässt sich an einem mehrfarbigen Glanz der Photoschalterstruktur aufgrund von optischen Interferenzeffekten erkennen.

Insbesondere im Hinblick auf die Realisierung einer Solarzelle mit der erfindungsgemäßen Photoschalterstruktur wird es bevorzugt, wenn das Halbleitersubstrat eine p-Zone aufweist und/oder auf der der SiNx-Schicht abgewandten Seite des Halbleitersubstrats eine Rückseitenelektrode vorgesehen ist. Die Rückseitenelektrode kann aus einem hochdotierten p-leitenden Material gebildet sein. Außerdem kann eine Transferelektrode vorgesehen sein, die die SiNx-Schicht durchdringt und die n-Zone kontaktiert. Zweckmäßigerweise ist die Transferelektrode zwischen der Anode und der Kathode angeordnet.

Die der Erfindung zugrunde liegende Aufgabe wird ferner gelöst durch ein Verfahren zur Herstellung einer Photoschalterstruktur gemäß Anspruch 10. Vorteilhafte Ausgestaltungen sind Gegenstand der abhängigen Ansprüche.

Das Ausbilden der Anode kann ein Bestrahlen der SiNx-Schicht mittels eines gepulsten Lasers umfassen. Es wird bevorzugt, wenn ein Laser mit einer Strahlbreite zwischen 1 und 3 mm und/oder einer Strahllänge zwischen 1 und 5 cm und/oder einer rechteckigen Strahlform und/oder einer Wellenlänge zwischen 500 und 550 nm und/oder einer Energiedichte zwischen 100 und 300 mJ·cm⁻² und/oder einer Pulsweite zwischen 6 und 18 ns und/oder einer Abtastgeschwindigkeit zwischen 0,1 und 0,5 mm·s⁻¹ verwendet wird.

Die Isolierschicht ist insbesondere aus Siliziumdioxid.

Das Ausbilden der SiNx-Schicht erfolgt bevorzugt durch plasmaunterstützte chemische Gasphasenabscheidung (PECVD). Besonders bevorzugt werden während der plasmaunterstützten chemischen Gasphasenabscheidung stickstoffverdünntes Monosilan und, insbesondere hochreines, Ammoniak als Arbeitsgase, insbesondere mit einem Strömungsverhältnis zwischen 1:2 und 1:5, verwendet. Ferner kann das Halbleitersubstrat auf 100 °C bis 300 °C erwärmt werden und/oder eine HF-Leistung zwischen 50 und 200 Watt verwendet werden. Das Monosilan kann in 5 bis 15-prozentiger Verdünnung im Stickstoff vorliegen.

Während der plasmaunterstützten chemischen Gasphasenabscheidung kann ein Arbeitsdruck zwischen 20 und 50 Pa verwendet werden. Dies ermöglicht ein schnelles Ausbilden der SiNx-Schicht. Alternativ kann vorgesehen sein, dass während der plasmaunterstützten chemischen Gasphasenabscheidung kann ein Arbeitsdruck zwischen 5 und 10 mTorr verwendet wird. Bei der Verwendung eines solchen Niederdruckverfahrens kann die SiNx-Schicht langsam ausgebildet werden.

Das Ausbilden der Anode und/oder der Kathode erfolgt insbesondere durch Siebdrucken. Dabei kann eine Aufschlämmungsschicht auf die für die Elektrode vorgesehenen Bereiche der SiNx-Schicht bzw. des Halbleitersubstrats aufgebracht werden. Bevorzugt wird die Aufschlämmungsschicht getrocknet und/oder einer Wärmebehandlung unterzogen.

Die der Erfindung zugrunde liegende Aufgabe wird schließlich gelöst durch eine Anordnung gemäß Anspruch 15.

Sämtliche Ausführungen zur zuvor beschriebenen Photoschalterstruktur lassen sich analog auf das erfindungsgemäße Herstellungsverfahren übertragen, sodass auch mit diesen die hinsichtlich der Solarzelle beschriebenen Vorteile erzielt werden können.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine Prinzipskizze einer geschnittenen Darstellung eines Ausführungsbeispiels der erfindungsgemäßen Anordnung mit einem Ausführungsbeispiel der erfindungsgemäßen Photoschalterstruktur;
- Fig. 2: eine Prinzipskizze einer Draufsicht auf das Ausführungsbeispiel der Photoschalterstruktur; und
- Fig. 3: ein Flussdiagramm eines Ausführungsbeispiel des erfindungsgemäßen Herstellungsverfahrens.

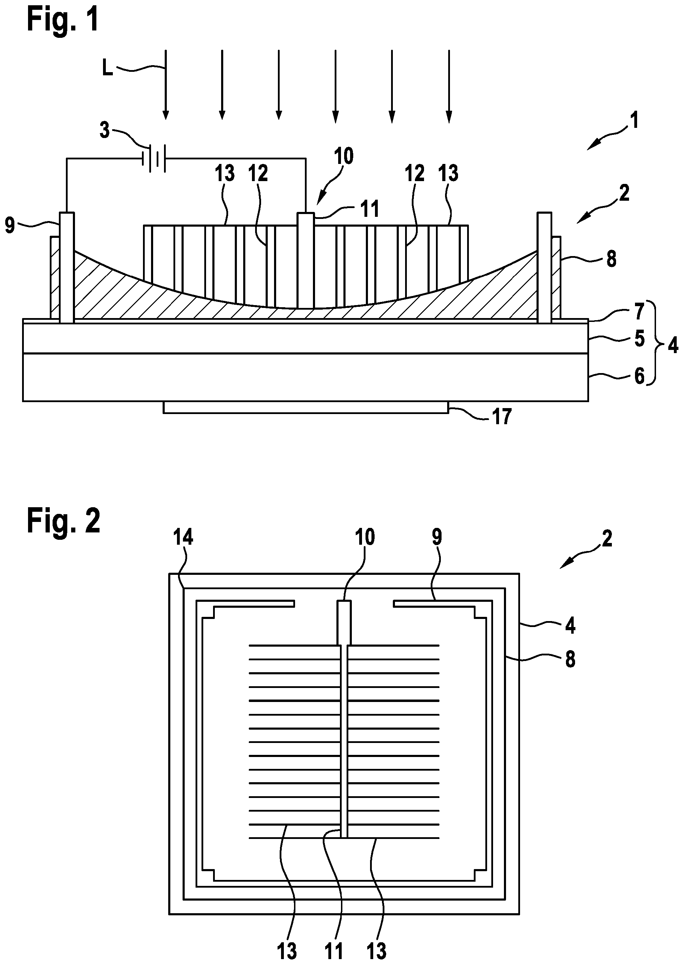

Fig. 1 ist eine Prinzipskizze in einer geschnittenen Darstellung eines Ausführungsbeispiels einer Anordnung 1 mit einem Ausführungsbeispiel einer Photoschalterstruktur 2 und mit einer Spannungsquelle 3

Die Solarzelle 2 umfasst ein Halbleitersubstrat 4 auf Basis von kristallinem Silizium mit einer hochdotierten n-Zone 5 und einer p-Zone 6 sowie einer unmittelbar auf der n-Zone 5 angeordneten ultradünnen Isolierschicht 7 mit einer Dicke zwischen 5 und 10 nm. Auf dem Halbleitersubstrat 4 ist n-zonenseitig eine hydrogenisierte SiNx-Schicht 8 angeordnet. Daneben umfasst die Solarzelle 2 eine Kathode 9, welche die SiNx-Schicht 8 durchdringt und die n-Zone 5 kontaktiert. Auf der SiNx-Schicht 8 ist eine Anode 10 aus Silber angeordnet.

Die Photoschalterstruktur 2 ist dazu eingerichtet, bei einer Bestrahlung der SiNx-Schicht 8 mit Licht L im Sonnenspektrum (beispielsweise unter Zugrundlegung eines Luftmassenkoeffizienten der Klasse AM1.5) in einen nichtlinear leitenden Zustand zu schalten, wenn zwischen der Anode 10 und der Kathode 9 eine von der Spannungsquelle 3 bereitgestellte externe Spannung von 2 bis 6 Volt angelegt wird.

Die Anode 10 weist einen die SiNx-Schicht 8 kontaktierenden Hauptabschnitt 11 und dessen zu beiden Seiten Nebenabschnitte 12 auf, die ebenfalls die SiNx-Schicht 8 kontaktieren. Der Hauptabschnitt 11 und die Nebenabschnitte 12 erstrecken sich senkrecht zur n-Zone 5. Gruppen von Nebenabschnitten 12 sind jeweils mittels eines Verbindungsabschnitts 13, der senkrecht vom Hauptabschnitt 11 absteht (vgl. Fig. 2), mit dem Hauptabschnitt 11 verbunden. Ein solches Design kann auch als Fischflossenstruktur bezeichnet werden.

Die SiNx-Schicht 8 weist einen flächenbezogenen Wasserstoffgehalt in Bereichen, die zwischen einem von der Anode 10 kontaktierten Bereich und dem Halbleitersubstrat 4 liegen, von wenigstens 2·10¹⁸ cm⁻² auf. So wird ein Übergang in Form eines makroskopischen Quantensystem (MQS) der Photoschalterstruktur 2 mit einer Bandlücke von weniger als 10 meV gebildet. Der flächenbezogene Wasserstoffgehalt der SiNx-Schicht 8 beträgt außerhalb dieser Bereiche weniger als 2·10¹⁶ cm⁻² und es sind siliziumreiche Quantenpunkte vorhanden. Dadurch wird ein hoher Transmissionsgrad, eine geringe Wärmeleitfähigkeit und ein passivierter Schutzfilm realisiert.

Auf ihrer vom Halbleitersubstrat 4 abgewandten Seite ist die SiNx-Schicht 8 konzentrisch konkav mit einem gestuften, im Wesentlichen parabolischen Profil ausgebildet. Daraus ergibt sich mehrfarbiger Glanz bei der Bestrahlung mit dem Licht L aufgrund von optischen Interferenzeffekten. Die Dicke der SiNx-Schicht 8 beträgt an der dünnsten Stelle zwischen 800 Å und 1500 Å und an der dicksten Stelle, also an Randpunkten 14 (siehe Fig. 2) zwischen 3000 Å und 1 µm. Die Photoschalterstruktur 2 kann insofern auch als SiNx-Dünnfilmschalter aufgefasst werden.

Im nichtlinearen leitenden Zustand weist die Photoschalterstruktur 2 einen flächenbezogenen Widerstand zwischen 0,5 und 3 Ω·cm⁻² auf. Im nicht mit dem Licht L bestrahlten Zustand beträgt der flächenbezogene Widerstand zwischen 500 und 2000 Ω·cm⁻² bei einer Durchbruchfeldstärke von 3·10⁵ V·cm⁻¹.

Die Kathode 9 ist ebenfalls aus Silber gebildet und weist eine rechteckige Form auf. Ferner ist eine die p-Zone kontaktierende, Rückseitenelektrode 15 aus einem hochdotierten p-leitenden Material vorgesehen.

Bei einer externen Spannung von 0 V stellt die Photoschalterstruktur 2 bei der Bestrahlung mit dem Licht L eine Leerlaufspannung zwischen der Kathode 9 und der Rückseitenelektrode 15 von rund 0,5 bis 0,7 V bereit. Eine Extraktion heißer Ladungsträger, die durch das Licht L angeregt werden, in Form von heißen Elektronen und heißen Löcher in MQS-Quantenübergangspaaren ist eingeschränkt. Auch wenn die externe Spannung 2 bis 6 Volt beträgt, aber keine Bestrahlung mit dem Licht L erfolgt, ist die Funktion des MQS-Übergangs eingeschränkt. Über der Kathode 9 und der Rückseitenelektrode 15 kann dann eine Leerlaufspannung von unter 1,2 V abgegriffen werden.

Bei der Bestrahlung mit dem Licht L und einem Wert der externen Spannung zwischen 2 und 6 Volt geht die Photoschalterstruktur 2 bzw. der MQS-Übergang jedoch in den nichtlinear leitenden Zustand über und ermöglicht eine schnelle Selektion und Extraktion heißer Elektronen im Subpikosekundenbereich. Unter dem Einfluss des elektrischen Felds wird die Beweglichkeit der heißen Ladungsträger erheblich erhöht. Die heißen Ladungsträger gehen von einer unkontrollierten thermischen Diffusionsbewegung zu einer Driftbewegung über. Dadurch sinken auch Rekombinationsverluste und Verluste durch überschüssige Wärmeenergie, die durch Kollisionen der heißen Ladungsträger verursacht wird. In diesem Zustand kann die Leerlaufspannung um den Faktor 2 bis 5 erhöht werden.

Das durch die externe Spannung erzeugte elektrische Feld versursacht eine Stoßionisation der Elektronen zwischen der SiNx-Schicht 8 und dem Halbleitersubstrat 4. Im Hinblick auf einen Betrieb der Anordnung 1 als Solarzelle kann so ein Kurzschlussstrom im Vergleich zu Solarzellen ohne Photoschalterstruktur um bis zu 30 % erhöht werden.

Bezüglich des AM1.5-Spektrum des Lichts L kann ein Wirkungsgrad der als Solarzelle betriebenen Photoschalterstruktur 2 von mehr als 32 % erzielt werden. Dabei ist zu beachten, dass die Verlustleistung durch das Anlegen der externen Spannung lediglich in der Größenordnung von 5 bis 10 % der maximalen Ausgangsleistung einer solchen Solarzelle liegt.

Befindet sich die Photoschalterstruktur 2 im nichtlinear leitenden Zustand, werden durch die Bestrahlung des im Halbleitersubstrat 4 vorhandenen pn-Übergangs mit dem Licht L freie Elektronen in der n-Zone 5 in die Kathode 9 injiziert, wodurch eine Elektroneninjektionsquelle gebildet wird. Die externe Spannung kann dann auch unter 2 V gesenkt werden und der nichtlinear leitende Zustand wird aufrechterhalten.

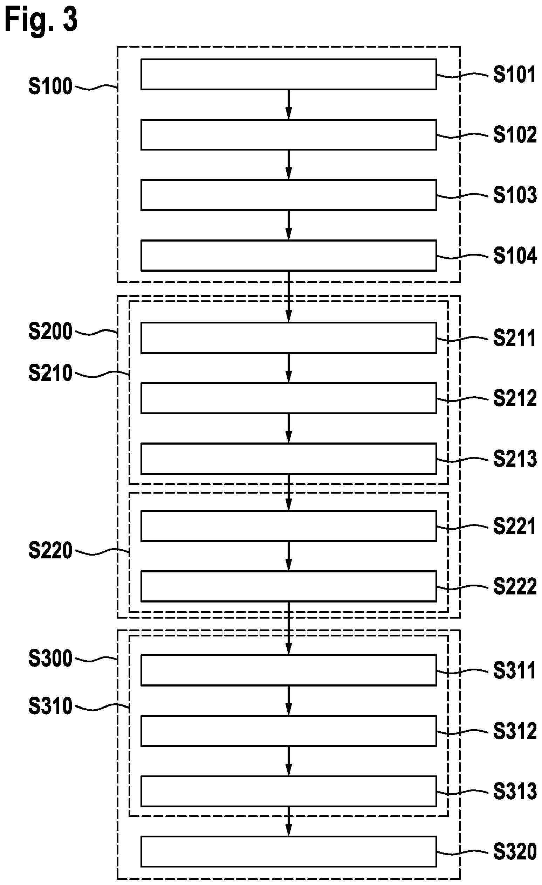

Fig. 3 ist ein Flussdiagramm eines Ausführungsbeispiels eines Verfahrens zur Herstellung einer Photoschalterstruktur 2. Im Rahmen der folgenden Erläuterung des Ausführungsbeispiels werden für einzelne Komponenten der Photoschalterstruktur 2 die Bezugszeichen der Fig. 1 und 2 für identische oder gleichwertige Komponenten verwendet.

Ein Schritt S100 des Bereitstellens eines Halbleitersubstrats 4 umfasst Schritte S101 bis S104. Im Schritt S101 wird ein Chip auf Basis von kristallinem Silizium mit einer hochdotierten n-Zone 5 und einer p-Zone 6 bereitgestellt, wobei die Zonen 5, 6 einen pn-Übergang ausbilden. Der Chip hat eine quadratische Grundfläche mit einer Seitenlänge zwischen 1 und 16 cm, hier 12 cm. Im Schritt S102 wird der Chip gereinigt. Im Schritt S103 wird der gereinigte Chip getrocknet. Dies erfolgt unter Reinraumbedingungen bei einer Temperatur von 100 °C für eine Dauer von 30 min. Im Schritt S104 wird eine Isolierschicht 7 auf einer Oberfläche der n-Zone 5 ausgebildet. Die Isolierschicht 7 hat eine Dicke zwischen 5 und 10 nm und wird aus Siliziumdioxid gebildet.

In einem an den Schritt S100 anschließenden Schritt S200 werden eine SiNx-Schicht 8 sowie eine Kathode 9, welche die SiNx-Schicht 8 durchdringt und die n-Zone 5 kontaktiert, ausgebildet. Der Schritt S200 umfasst dabei einen Schritt S210 des Ausbildens der Kathode 9 und einen Schritt S220 des Ausbildens der SiNx-Schicht 8.

Der Schritt S210 umfasst wiederum Schritte S211 bis S213. Im Schritt S211 wird durch Siebdrucken eine Aufschlämmungsschicht mit Silber auf den für die Kathode 9 vorgesehenen Bereich des Halbleitersubstrats 4 aufgebracht. Die Aufschlämmungsschicht hat jeweils eine Dicke von 1530 µm. Die Kathode 9 wird quadratisch mit einer Breite von 1,5 mm geformt. Im Schritt S212 wird die Aufschlämmungsschicht getrocknet. Dies erfolgt bei einer Temperatur von 100 °C für 30 min. In einem anschließenden Schritt S213 wird eine Wärmebehandlung des Halbleitersubstrats 4 durchgeführt. Dies erfolgt in einer Stickstoffatmosphäre bei einer Temperatur zwischen 250 °C und 400 °C für 5 bis 10 min. Dadurch wird die Kathode 9 die n-Zone 5 kontaktierend auf dem Halbleitersubstrat 4 ausgebildet.

Der an den Schritt S210 anschließende Schritt S220 des Ausbildens der SiNx-Schicht 8 umfasst seinerseits Schritte S221 und S222. Im Schritt S221 wird das Halbleitersubstrat 4 auf einer Isolierplatte aus Quarz angeordnet und in einen Vakuumraum einer Vorrichtung zur plasmaunterstützten chemischen Gasphasenabscheidung positioniert. Im Schritt S222 wird die SiNx-Schicht 8 die Kathode 9 einfassend durch plasmaunterstützte chemische Gasphasenabscheidung (PECVD) ausgebildet. Dazu wird das Halbleitersubstrat 4 auf 100 °C bis 300°C, hier 200 °C, erwärmt. Als Arbeitsgase werden stickstoffverdünntes Monosilan und Ammoniak in einem Verhältnis zwischen 1:2 und 1:5, hier 1:3, verwendet, wobei das Monosilan in einer 10-prozentigen Verdünnung in Stickstoff vorliegt. Ein Arbeitsdruck der PECVD beträgt 30 Pa bei einer HF-Leistung zwischen 50 und 200 W, hier 70 W, mit einer Frequenz von 13,56 MHz. Die PECVD wird für eine Dauer von 20 min durchgeführt. Dabei wird die SiNx-Schicht 8 schichtweise ausgebildet, sodass die Dicke der SiNx-Schicht 8 mittig 900 Å beträgt und stufenweise auf eine Dicke von 4500 Å an ihrem äußersten Rand ansteigt. Die SiNx-Schicht 8 wird folglich konkav ausgebildet.

An den Schritt S200 schließt sich ein Schritt S300 des Ausbildens einer Anode 10 auf der SiNx-Schicht 8 an, so dass die Photoschalterstruktur 2 bei einer Bestrahlung der SiNx-Schicht 8 mit Licht L in einen nichtlinearen leitenden Zustand schalten kann, wenn zwischen der Anode 10 und der Kathode 9 eine externe Spannung anliegt. Der Schritt S300 umfasst einen Schritt S310 und einen Schritt S320.

Im Schritt S310 wird zunächst die Anode 10 auf der SiNx-Schicht 8 ausgebildet, was wiederum Schritte S311 bis S313 umfasst. Im Schritt S311 wird durch Siebdrucken eine Aufschlämmungsschicht mit Silber auf den für die Anode 10 vorgesehenen Bereichen der SiNx-Schicht 8 aufgebracht. Dies erfolgt derart, dass die Anode 10 einen die SiNx-Schicht 8 kontaktierenden Hauptabschnitt 11 und zu dessen beiden Seiten Nebenabschnitte 12 erhält, die ebenfalls die SiNx-Schicht 8 kontaktieren. Der Hauptabschnitt 11 und die Nebenabschnitte 12 erstrecken sich senkrecht zur n-Zone 5 und weisen eine Dicke zwischen 15 und 30 µm auf. Eine Breite des Hauptabschnitts 11 beträgt 1 mm. Die Nebenabschnitte 12 weisen eine Breite zwischen 100 und 500 µm auf und bilden über eine Länge von 10 bis 40 mm auf jeder Seite ein gitterartiges Raster mit einem Abstand von 2 bis 6 mm zueinander. Gruppen von Nebenabschnitten 12, die auf einer jeweiligen Seite des Hauptabschnitts 11 senkrecht in einer Line zum Hauptabschnitt 11 angeordnet sind, sind jeweils mittels eines Verbindungsabschnitts 13 mit dem Hauptabschnitt 11 verbunden. Ein solches Design kann auch als Fischflossenstruktur bezeichnet werden. Die Aufschlämmungsschicht wird im Schritt S312 getrocknet. Dies erfolgt bei 150 °C für 30 min. Anschließend wird die getrocknete Aufschlämmungsschicht im Schritt S313 einer Wärmebehandlung unterzogen. Dies erfolgt für eine Dauer von 10 bis 30 min bei 300 °C in einer Stickstoffatmosphäre.

Der Schritt S320 ist ein Bestrahlen der SiNx-Schicht 8 mit einem gepulsten Laser. Dazu wird ein Nanosekundenlaserstrahl mit einer Wellenlänge zwischen 500 und 550 nm, hier 532 nm, expandiert, geformt und durch einen zylindrischen Spiegel zu einer Strahlbreite zwischen 1 und 3 mm, hier zu einem bandförmigen Strahl von 2 × 30 mm, und einer Strahllänge zwischen 1 und 5 cm fokussiert. Mit einer Geschwindigkeit zwischen 0,1 und 0,5 mm·s⁻¹, hier 0,4 mm·s⁻¹, werden durch die Anode 10 kontaktierte Bereiche des SiNx-Schicht 8 durch den Laser bestrahlt. Es wird ein Laser mit einer Pulsweite von zwischen 6 und 18 ns, hier 12 ns, und einer Energiedichte von zwischen 100 und 300 mJ·cm⁻², hier 150 mJ·cm⁻², verwendet. Dadurch wird eine flächenbezogene Wasserstoffkonzentration von wenigstens 2·10¹⁸ cm⁻² realisiert, wohingegen die flächenbezogene Wasserstoffkonzentration in übrigen Bereichen der SiNx-Schicht 8 unter 2·10¹⁶ cm⁻² liegt.

Gemäß einem weiteren Ausführungsbeispiel des Herstellungsverfahrens wird das PECVD im Schritt S222 für eine Dauer von 10 min durchgeführt, wobei die dünnste Stelle der SiNx-Schicht 8 eine Dicke von 900 Å und ihre dickste Stelle eine Dicke von 2800 Å aufweist.

Gemäß einem weiteren Ausführungsbeispiel des Herstellungsverfahrens wird das PECVD im Schritt S222 als Niederdruckverfahren durchgeführt. Dabei beträgt der Arbeitsdruck zwischen 5 und 10 mTorr.

## Patentansprüche

1. Photoschalterstruktur (2), umfassend
- ein Halbleitersubstrat (4) mit einer n-Zone (5) und einer auf der n-Zone (5) ausgebildete Isolierschicht (7),
- eine n-zonenseitig auf dem Halbleitersubstrat (4) angeordnete hydrogenisierte SiNx-Schicht (8),
- eine die n-Zone (5) kontaktierende Kathode (9) und
- eine die SiNx-Schicht (8) kontaktierende Anode (10),
wobei ein flächenbezogener Wasserstoffgehalt in Bereichen der SiNx-Schicht (8), die zwischen einem von der Anode (10) kontaktierten Bereich und dem Halbleitersubstrat (4) liegen, wenigstens um den Faktor 10 höher ist als in übrigen Bereichen der SiNx-Schicht (8), wobei die Photoschalterstruktur (2) dazu eingerichtet ist, bei einer Bestrahlung der SiNx-Schicht (8) mit Licht (L) in einen nichtlinearen leitenden Zustand zu schalten, wenn zwischen der Anode (10) und der Kathode (9) eine externe Spannung anliegt.

2. Photoschalterstruktur nach Anspruch 1, wobei
die Photoschalterstruktur (2) dazu eingerichtet ist, ihren flächenbezogenen Widerstand beim Übergang von einem nicht mit Licht (L) bestrahlten Zustand in den nichtlinear leitenden Zustand um einen Faktor zwischen 300 und 4000 zu verringern.

3. Photoschalterstruktur nach Anspruch 1 oder 2, wobei
die Kathode (9) die SiNx-Schicht (8) durchdringt.

4. Photoschalterstruktur nach einem der vorhergehenden Ansprüche, wobei die Anode (10) einen die SiNx-Schicht (8) kontaktierenden Hauptabschnitt (11) und ein oder mehrere vom Hauptabschnitt (11) abstehende, die SiNx-Schicht (8) nicht kontaktierende Verbindungsabschnitte (13) aufweist, wobei von dem oder einem jeweiligen Verbindungsabschnitt (13) ein oder mehrere die SiNx-Schicht (8) kontaktierende Nebenabschnitte (12) abstehen.

5. Photoschalterstruktur nach Anspruch 4, wobei die Verbindungabschnitte (13) an zwei gegenüberliegenden Seiten des Hauptabschnitts (11) ausgebildet sind.

6. Photoschalterstruktur nach einem der vorhergehenden Ansprüche, ferner umfassend eine Transferelektrode, die die SiNx-Schicht (8) durchdringt und die n-Zone (5) kontaktiert.

7. Photoschalterstruktur nach einem der vorhergehenden Ansprüche, wobei der flächenbezogene Wasserstoffgehalt in den Bereichen der SiNx-Schicht (8), die zwischen dem von der Anode (10) kontaktierten Bereich und dem Halbleitersubstrat (4) liegen, wenigstens um den Faktor 100 höher ist, als in den übrigen Bereichen der SiNx-Schicht (8).

8. Photoschalterstruktur nach einem der vorhergehenden Ansprüche, wobei die SiNx-Schicht (8) auf einer vom Halbleitersubstrat (4) abgewandten Seite konkav ausgebildet ist.

9. Photoschalterstruktur nach einem der vorhergehenden Ansprüche, wobei das Halbleitersubstrat (4) eine p-Zone (6) aufweist und/oder auf der der SiNx-Schicht (8) abgewandten Seite des Halbleitersubstrats (4) eine Rückseitenelektrode (15) vorgesehen ist.

10. Verfahren zur Herstellung einer Photoschalterstruktur (2), umfassend folgende Schritte:
- Bereitstellen eines Halbleitersubstrats (4) mit einer n-Zone (5), wobei das Halbleitersubstrat eine auf der n-Zone (5) ausgebildete Isolierschicht (7) aufweist oder eine Isolierschicht (7) unmittelbar auf der n-Zone (5) ausgebildet wird;
- Ausbilden einer hydrogenisierten SiNx-Schicht (8) und einer Kathode (9), welche die n-Zone (5) kontaktiert, auf dem Halbleitersubstrat (4); und
- Ausbilden einer Anode (10) auf der SiNx-Schicht (8), so dass die Photoschalterstruktur (2) bei einer Bestrahlung der SiNx-Schicht (8) mit Licht (L) in einen nichtlinearen leitenden Zustand schalten kann, wenn zwischen der Anode (10) und der Kathode (9) eine externe Spannung anliegt,
wobei ein flächenbezogener Wasserstoffgehalt in Bereichen der SiNx-Schicht (8), die zwischen einem von der Anode (10) kontaktierten Bereich und dem Halbleitersubstrat (4) liegen, wenigstens um den Faktor 10 höher ist als in übrigen Bereichen der SiNx-Schicht (8).

11. Verfahren nach Anspruch 10, wobei das Ausbilden der Anode (10) ein Bestrahlen der SiNx-Schicht (8) mittels eines gepulsten Lasers umfasst.

12. Verfahren nach Anspruch 11, wobei ein Laser mit
- einer Strahlbreite zwischen 1 und 3 mm und/oder
- einer Strahllänge zwischen 1 und 5 cm und/oder
- einer rechteckigen Strahlform und/oder
- einer Wellenlänge zwischen 500 und 550 nm und/oder
- einer Energiedichte zwischen 100 und 300 mJ/cm² und/oder
- einer Pulsweite zwischen 6 und 18 ns und/oder
- einer Abtastgeschwindigkeit zwischen 0,1 und 0,5 mm/s
verwendet wird.

13. Verfahren nach einem der Ansprüche 10 bis 12, wobei das Ausbilden der SiNx-Schicht (8) durch plasmaunterstützte chemische Gasphasenabscheidung erfolgt.

14. Verfahren nach Anspruch 13, wobei während der plasmaunterstützten chemischen Gasphasenabscheidung
- stickstoffverdünntes Monosilan und Ammoniak als Arbeitsgase, insbesondere mit einem Strömungsverhältnis zwischen 1:2 und 1:5 verwendet, und/oder
- das Halbleitersubstrat auf 100 °C bis 300 °C erwärmt wird und/oder
- ein Arbeitsdruck zwischen 20 und 50 Pa oder zwischen 5 und 10 mTorr verwendet wird und/oder
- eine HF-Leistung zwischen 50 und 200 Watt
verwendet wird.

15. Anordnung (1) mit einer Photoschalterstruktur (2) nach einem der Ansprüche 1 bis 9 oder einer durch ein Verfahren nach einem der Ansprüche 10 bis 14 erhaltenen Photoschalterstruktur (2) und mit einer Spannungsquelle (3), die zur Bereitstellung der externen Spannung an die Anode (10) und die Kathode (9) angeschlossen ist.

## Claims

1. A photoswitch structure (2) comprising
- a semiconductor substrate (4) having an n-type region (5) and an insulating film (7) formed on the n-type region (5),
- a hydrogenated SiNx layer (8) disposed on the n-type region of the semiconductor substrate (4),
- a cathode (9) contacting the n-type region (5) and
- an anode (10) contacting the SiNx layer (8),
wherein an area-related hydrogen content in regions of the SiNx layer (8) which lie between a region contacted by the anode (10) and the semiconductor substrate (4) is higher by at least a factor of 10 than in other regions of the SiNx layer (8) wherein the photoswitch structure (2) is arranged to switch to a non-linear conductive state upon irradiation of the SiNx layer (8) with light (L) when an external voltage is applied between the anode (10) and the cathode (9).

2. The photoswitch structure according to claim 1, wherein
the photoswitch structure (2) is arranged to reduce its area-related resistance by a factor between 300 and 4000 during the transition from a state not irradiated with light (L) to the non-linearly conducting state.

3. The photoswitch structure according to claim 1 or 2, wherein
the cathode (9) penetrates the SiNx layer (8).

4. The photoswitch structure according to any one of the preceding claims, wherein the anode (10) comprises a main portion (11) contacting the SiNx layer (8) and one or more connecting portions (13) projecting from the main portion (11) and not contacting the SiNx layer (8), wherein one or more secondary portions (12) contacting the SiNx layer (8) project from the or a respective connecting portion (13).

5. The photoswitch structure according to claim 4, wherein the connecting portions (13) are formed on two opposite sides of the main portion (11).

6. The photoswitch structure according to any one of the preceding claims, further comprising a transfer electrode penetrating the SiNx layer (8) and contacting the n-type region (5).

7. The photoswitch structure according to any one of the preceding claims, wherein the hydrogen content per unit area in the regions of the SiNx layer (8) which lie between the region contacted by the anode (10) and the semiconductor substrate (4) is higher by at least a factor of 100 than in the other regions of the SiNx layer (8).

8. The photoswitch structure according to any one of the preceding claims, wherein the SiNx layer (8) is concave on a side facing away from the semiconductor substrate (4).

9. The photoswitch structure according to any one of the preceding claims, wherein the semiconductor substrate (4) comprises a p-zone (6) and/or a backside electrode (15) is provided on the side of the semiconductor substrate (4) facing away from the SiNx layer (8).

10. A method of manufacturing a photoswitch structure (2) comprising the following steps:
- providing a semiconductor substrate (4) having an n-type region (5), wherein said semiconductor substrate has an insulating layer (7) formed on said n-type region (5) or an insulating layer (7) is formed directly on said n-type region (5);
- forming a hydrogenated SiNx layer (8) and a cathode (9) contacting the n-type region (5) on the semiconductor substrate (4); and
- forming an anode (10) on the SiNx layer (8) so that the photoswitch structure (2) can switch to a non-linear conductive state upon irradiation of the SiNx layer (8) with light (L), when an external voltage is applied between the anode (10) and the cathode (9),
wherein an area-related hydrogen content in regions of the SiNx layer (8) which lie between a region contacted by the anode (10) and the semiconductor substrate (4) is higher by at least a factor of 10 than in other regions of the SiNx layer (8).

11. The method according to claim 10, wherein forming the anode (10) comprises irradiating the SiNx layer (8) using a pulsed laser.

12. The method according to claim 11, wherein a laser with
- a beam width between 1 and 3 mm and/or
- a beam length of between 1 and 5 cm, and/or
- a rectangular beam shape and/or
- a wavelength between 500 and 550 nm and/or
- an energy density of between 100 and 300 mJ/cm², and/or
- a pulse width between 6 and 18 ns and/or
- a scanning speed between 0.1 and 0.5 mm/s
is used.

13. The method according to any one of claims 10 to 12, wherein the formation of the SiNx layer (8) is by plasma-assisted chemical vapor deposition.

14. The method according to claim 13, wherein during plasma assisted chemical vapor deposition.
- nitrogen-diluted monosilane and ammonia are used as working gases, in particular with a flow ratio between 1:2 and 1:5, and/or
- the semiconductor substrate is heated to 100 °C to 300 °C and/or
- a working pressure between 20 and 50 Pa or between 5 and 10 mTorr is used and/or
- an RF power between 50 and 200 watts
is used.

15. A device (1) comprising a photoswitch structure (2) according to any one of claims 1 to 9 or a photoswitch structure (2) obtained by a method according to any one of claims 10 to 14, and a voltage source (3) connected to the anode (10) and the cathode (9) for providing the external voltage.

## Revendications

1. Structure de commutateur photoélectrique (2), comprenant
- un substrat semi-conducteur (4) avec une n-zone (5) et une couche isolante (7) formée sur la n-zone (5),
- une couche SiNx (8) hydrogénée côté n-zone disposée sur le substrat semi-conducteur (4),
- une cathode (9) en contact avec la n-zone (5) et
- une anode (10) en contact avec la couche SiNx (8),
en ce qu'une teneur en hydrogène surfacique dans des zones de la couche SiNx (8), qui se trouvent entre une zone en contact par l'anode (10) et le substrat semi-conducteur (4), est au moins supérieure du facteur 10 à celle dans des autres zones de la couche SiNx (8), en ce que la structure de commutateur photoélectrique (2) est conçue pour commuter dans un état conducteur non linéaire lors d'une irradiation de la couche SiNx (8) par de la lumière (L), lorsqu'une tension externe est appliquée entre l'anode (10) et la cathode (9).

2. Structure de commutateur photoélectrique selon la revendication 1, en ce que la structure de commutateur photoélectrique (2) est conçue pour réduire sa résistance surfacique d'un facteur compris entre 300 et 4000 lors du passage d'un état non irradié par de la lumière (L) à l'état conducteur non linéaire.

3. Structure de commutateur photoélectrique selon la revendication 1 ou 2, en ce que la cathode (9) pénètre la couche SiNx (8).

4. Structure de commutateur photoélectrique selon l'une des revendications précédentes, en ce que l'anode (10) comporte une section principale (11) en contact avec la couche SiNx (8) et une ou plusieurs sections de liaison (13) saillantes de la section principale (11), n'étant pas en contact avec la couche SiNx (8), en ce qu'une ou plusieurs sections secondaires (12) en contact avec la couche SiNx (8) font saillie de la ou d'une section de liaison (13) respective.

5. Structure de commutateur photoélectrique selon la revendication 4, en ce que les sections de liaison (13) sont formées sur deux côtés opposés de la section principale (11).

6. Structure de commutateur photoélectrique selon l'une des revendications précédentes, comprenant en outre une électrode de transfert qui pénètre la couche SiNx (8) et établit un contact avec la n-zone (5).

7. Structure de commutateur photoélectrique selon l'une des revendications précédentes, en ce que la teneur en hydrogène surfacique dans les zones de la couche SiNx (8), qui se trouvent entre la zone en contact par l'anode (10) et le substrat semi-conducteur (4), est au moins supérieure du facteur 100 à celle dans les autres zones de la couche SiNx (8).

8. Structure de commutateur photoélectrique selon l'une des revendications précédentes, en ce que la couche SiNx (8) est réalisée de manière concave sur un côté opposé au substrat semi-conducteur (4).

9. Structure de commutateur photoélectrique selon l'une des revendications précédentes, en ce que le substrat semi-conducteur (4) comporte une p-zone (6) et/ou en ce qu'une électrode arrière (15) est prévue sur le côté opposé à la couche SiNx (8) du substrat semi-conducteur (4).

10. Procédé de fabrication d'une structure de commutateur photoélectrique (2), comprenant les étapes suivantes consistant à :
- fournir un substrat semi-conducteur (4) avec une n-zone (5), en ce que le substrat semi-conducteur comporte une couche isolante (7) formée sur la n-zone (5) ou en ce qu'une couche isolante (7) est formée directement sur la n-zone (5) ;
- former une couche SiNx (8) hydrogénée et une cathode (9), laquelle est en contact avec la n-zone (5), sur le substrat semi-conducteur (4) ; et
- former une anode (10) sur la couche SiNx (8), de telle sorte que la structure de commutateur photoélectrique (2) peut commuter dans un état conducteur non linéaire lors d'une irradiation de la couche SiNx (8) par de la lumière (L), lorsqu'une tension externe est appliquée entre l'anode (10) et la cathode (9), en ce qu'une teneur en hydrogène surfacique dans des zones de la couche SiNx (8), qui se trouvent entre une zone en contact par l'anode (10) et le substrat semi-conducteur (4), est au moins supérieure du facteur 10 à celle dans des autres zones de la couche SiNx (8).

11. Procédé selon la revendication 10, en ce que la formation de l'anode (10) comporte une irradiation de la couche SiNx (8) au moyen d'un laser pulsé.

12. Procédé selon la revendication 11, en ce qu'un laser
- d'une largeur de faisceau comprise entre 1 et 3 mm et/ou
- d'une longueur de faisceau comprise entre 1 et 5 cm et/ou
- d'une forme de faisceau rectangulaire et/ou
- d'une longueur d'onde comprise entre 500 et 550 nm et/ou
- d'une densité d'énergie comprise entre 100 et 300 mJ/cm² et/ou
- d'une largeur d'impulsions comprise entre 6 et 18 ns et/ou
- d'une vitesse de balayage comprise entre 0,1 et 0,5 mm/s
est utilisé.

13. Procédé selon l'une des revendications 10 à 12, en ce que la formation de la couche SiNx (8) se produit par séparation chimique en phase gazeuse assistée par plasma.

14. Procédé selon la revendication 13, en ce que durant la séparation chimique en phase gazeuse assistée par plasma
- du monosilane dilué à l'azote et de l'ammoniac sont utilisés comme gaz utiles, en particulier avec un rapport d'écoulement compris entre 1:2 et 1:5, et/ou
- le substrat semi-conducteur est chauffé à une température comprise entre 100 °C et 300 °C et/ou
- une pression de service comprise entre 20 et 50 Pa ou entre 5 et 10 m Torr est utilisée et/ou
- une puissance HF comprise entre 50 et 200 watts est utilisée.

15. Ensemble (1) comprenant une structure de commutateur photoélectrique (2) selon l'une des revendications 1 à 9 ou une structure de commutateur photoélectrique (2) obtenue par un procédé selon l'une des revendications 10 à 14 et une source de tension (3), qui est raccordée à l'anode (10) et à la cathode (9) pour fournir la tension externe.
